# FASCICULE DE BREVET EUROPEEN

(11) **EP 2 962 374 B1**
(45) Date de publication et mention de la délivrance du brevet: **05.04.2017**
(21) Numéro de dépôt: 14706570.0
(22) Date de dépôt: 25.02.2014
(51) Int. Cl.: H02G 5/10, C25C 7/00, C25B 9/04

(54) **ARCHITECTURE DE BARRE DE CONNEXION POUR CONVERTISSEUR DE FORTE PUISSANCE**
KONFIGURATION EINES VERBINDUNGSLEITERS FÜR HOCHLEISTUNGSSTROMRICHTER
CONFIGURATION OF A CONNECTION CONDUCTOR FOR A HIGH POWER CONVERTER

(30) Priorité: 28.02.2013 FR 1351817
(43) Date de publication de la demande: 06.01.2016
(73) Titulaire: General Electric Technology GmbH, 5400 Baden (CH)
(72) Inventeur: BELLANCOURT, Raphaël, ST17 9LU Stafford (GB); JOSSE, Philippe, F-75014 Paris (FR); DEVAUTOUR, Joël, F-78230 Le Pecq (FR)
(74) Mandataire: Brevalex
(86) Numéro de dépôt international: PCT/EP2014/053574
(87) Numéro de publication internationale: WO 2014/131740

(56) Documents cités:
- WO-A1-2012/114176
- WO-A2-2012/062707
- US-A- 3 354 261
- US-B1- 6 574 094

## Description

### DOMAINE TECHNIQUE

La présente invention se rapporte au domaine des convertisseurs de forte puissance dans l'électrolyse. De tels convertisseurs peuvent par exemple permettre la production d'aluminium, zinc, cuivre ou chlore par un processus de réduction électrolytique.

L'invention concerne plus particulièrement une barre de connexion destinée à assurer une connexion électrique entre un convertisseur de forte puissance et un sectionneur, et un circuit convertisseur comportant une telle barre de connexion.

### ÉTAT DE LA TECHNIQUE ANTÉRIEURE

Dans le domaine de l'électronique de puissance, les convertisseurs à semi-conducteur de forte puissance pour l'électrolyse sont typiquement des redresseurs qui assurent directement la conversion d'une source de courant alternatif en une source de courant continu. De tels redresseurs peuvent être de technologie à diodes, encore appelés redresseurs non contrôlés, ou de technologie à thyristors, encore appelés redresseurs contrôlés.

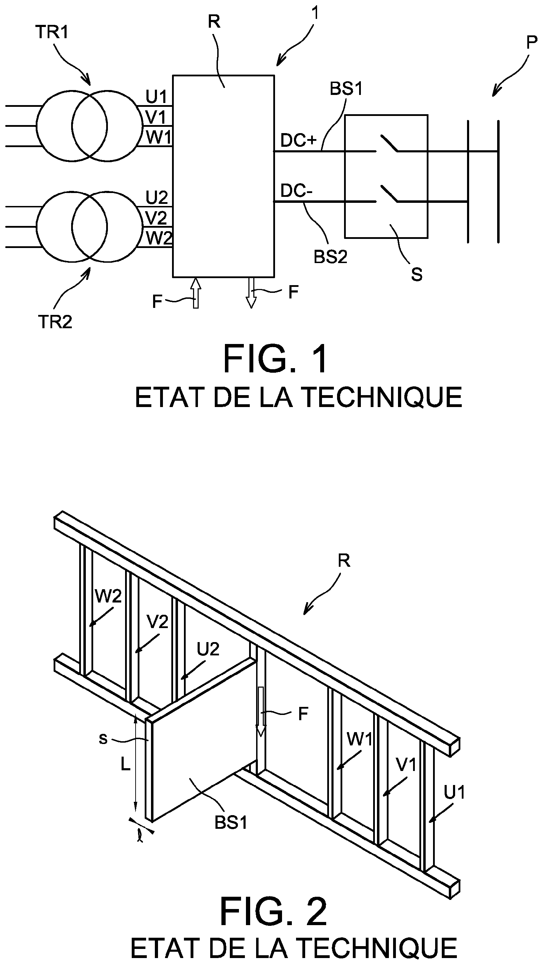

La figure 1 représente un schéma électrique simplifié d'un circuit redresseur 1 que l'on retrouve classiquement dans une installation d'usine d'électrolyse pour permettre l'alimentation en courant électrique de cuves d'électrolyse. Un tel circuit redresseur peut également être utilisé pour alimenter autre chose que des cuves d'électrolyse, par exemple des fours électriques à arc ou les générateurs de plasma qui nécessitent également de fortes puissances.

Le circuit redresseur 1 comporte un convertisseur de puissance sous la forme d'un redresseur R, alimenté en courant alternatif en entrée par deux transformateurs triphasés TR1 et TR2. En sortie, le redresseur R fournit à la série de cuves P (ou « potline » en anglais) un courant continu par l'intermédiaire d'un sectionneur S placé entre le redresseur R et la série de cuves P. Un fluide, notamment de l'eau, circule au niveau du redresseur R pour permettre son refroidissement (ce fluide est matérialisé par les flèches F sur la figure 1).

La transmission du courant entre le redresseur R et le sectionneur S est assurée grâce à la présence de barres de connexion situées entre le redresseur R et le sectionneur S. Ces barres de connexion comportent en particulier deux barres de connexion appelées barre de sortie continue (DC+) BS1 et barre de sortie continue (DC-) BS2.

La figure 2 représente schématiquement, en perspective, un convertisseur de puissance sous forme de redresseur R équipé d'une barre de sortie continue BS1 selon l'art antérieur. La barre de sortie continue BS2 n'est pas représentée mais sa forme est analogue à celle de la barre de sortie continue BS1. Comme on peut le voir sur cette figure 2, la barre de sortie continue BS1 présente une forme pleine, en particulier une forme générale de parallélépipède rectangle plein s'étendant depuis le redresseur R. Ce type de barre de sortie continue BS1 est généralement dimensionnée avec une densité de courant de 0,5 A/mm², ce qui conduit pour un convertisseur de forte puissance à avoir une section de raccordement s très importante. Par exemple, dans le cas d'un convertisseur d'un courant continu de 105 kA, la section s présente une longueur L de 140 cm pour une largeur 1 de 15 cm. Par ailleurs, le fluide de refroidissement circule uniquement au niveau du redresseur R, comme le matérialise la flèche F sur la figure 2.

La demande internationale WO 2012/114176 A1, les brevets US 3,354,261 A et US 6,574,094 B1, et la demande internationale WO 2012/062707 A2 décrivent encore d'autres réalisations selon l'art antérieur.

La conception des barres de connexion selon l'art antérieur entraîne plusieurs contraintes et inconvénients. En effet, les évolutions actuelles des convertisseurs de forte puissance tendent à augmenter la puissance de ces convertisseurs, se traduisant par l'augmentation des dimensions des barres de connexion et une augmentation des capacités de dissipation calorifique. Or, les barres de connexion selon l'art antérieur présentent des dimensionnements trop importants. De plus, les barres de connexion selon l'art antérieur ne permettent pas de refroidir le sectionneur. Il faut utiliser un circuit séparé, complexifiant le circuit hydraulique global.

### EXPOSÉ DE L'INVENTION

L'invention a pour but de remédier au moins partiellement aux besoins et aux inconvénients mentionnés ci-dessus, relatifs aux réalisations de l'art antérieur.

L'invention a ainsi pour objet, selon l'un de ses aspects, une barre de connexion destinée à assurer une connexion électrique entre un convertisseur de forte puissance et un sectionneur, appartenant notamment à une installation d'usine d'électrolyse, selon les caractéristiques de la revendication 1. Selon l'invention, la barre de connexion est destinée à assurer le passage d'un fluide de refroidissement permettant de refroidir la barre de connexion.

Par « barre de connexion », on entend tout type de structure de connexion électrique entre le convertisseur de puissance et le sectionneur, dont la forme peut être autre que celle d'une barre. En particulier, la barre de connexion est une barre de sortie continue, DC+ ou DC-.

Grâce à l'invention, il est possible d'optimiser et d'augmenter la puissance des convertisseurs de forte puissance grâce à une architecture spécifique des barres de connexion, avec une forme délimitant un creux, qui permet une réduction des dimensions et une circulation optimale du fluide de refroidissement. En outre, l'invention peut permettre un gain significatif en termes de masse des barres de connexion du fait de leur forme délimitant un creux. Par exemple, la masse d'aluminium est réduite de trois quarts facilitant ainsi le transport et la manutention. La masse totale de l'installation en fonctionnement, comprenant notamment l'aluminium et le fluide de refroidissement, est également réduite de moitié. Par ailleurs, le même circuit de refroidissement peut être utilisé pour refroidir le sectionneur et le convertisseur de puissance. En effet, la forme formant un creux des barres de connexion peut permettre une circulation dans celles-ci du fluide de refroidissement. Enfin, l'invention peut permettre un gain important en termes de coût de fabrication et de maintenance.

Ledit au moins un creux délimité au moins en partie par la barre de connexion peut s'apparenter à un espace vide formé au moins en partie par la barre de connexion.

La formation d'un tel creux par la barre de connexion peut permettre d'optimiser l'architecture de la barre de connexion et d'augmenter la puissance du convertisseur à forte puissance.

En particulier, les barres de connexion selon l'art antérieur sont habituellement réalisées en aluminium massif et leur masse importante a tendance à déséquilibrer l'ensemble du convertisseur. La réalisation d'une barre de connexion selon l'invention dont la forme délimite au moins partiellement un creux peut permettre d'alléger la masse de la barre de connexion et d'augmenter l'efficacité du convertisseur.

La barre de connexion est configurée pour permettre le passage d'un fluide de refroidissement à l'intérieur de celle-ci. Ainsi, la barre de connexion peut être refroidie par un tel fluide.

La barre de connexion peut être agencée pour que sa forme délimite en partie ledit au moins un creux et pour que l'autre partie dudit au moins un creux soit délimitée par le convertisseur à forte puissance. En particulier, ledit au moins un creux peut être formé et délimité totalement une fois la barre de connexion assemblée au convertisseur de forte puissance.

La barre de connexion comporte deux barres (ou sous-barres) destinées à venir au contact du convertisseur de forte puissance. Les deux barres sont reliées à une même base destinée à venir au contact du sectionneur.

Les deux barres peuvent être parallèles entre elles. Les deux barres peuvent être perpendiculaires à la base.

La base peut être apparentée à une barre, la barre de connexion comportant ainsi trois barres (ou sous-barres).

La barre de connexion présente une forme en U. En particulier, les deux barres et la base (ou troisième barre) peuvent former un U. Cette forme en U peut délimiter en partie un creux ou toute autre forme possible. L'autre partie du creux peut être délimitée par la partie du convertisseur située entre les deux barres une fois la barre de connexion assemblée au convertisseur de forte puissance.

La barre de connexion peut être une barre de sortie continue DC+ ou DC-.

La barre de connexion peut être démontable, notamment lorsqu'elle peut être fixée par vissage sur le convertisseur à forte puissance.

L'invention a encore pour objet, selon un autre de ses aspects, un circuit convertisseur, notamment pour une installation d'usine d'électrolyse, comportant un convertisseur de forte puissance et un sectionneur reliés électriquement entre eux, caractérisé en ce qu'il comporte de plus une barre de connexion telle que définie précédemment pour assurer une connexion électrique entre le convertisseur de forte puissance et le sectionneur.

Le convertisseur de forte puissance peut notamment être un redresseur.

Un même fluide de refroidissement peut circuler dans le convertisseur, la barre de connexion et le sectionneur. En particulier, un seul et unique circuit de refroidissement peut être prévu pour refroidir le convertisseur et le sectionneur.

Les deux barres peuvent être fixées au convertisseur de forte puissance par soudure.

Le circuit convertisseur peut comporter au moins un élément de montage fixé au convertisseur de forte puissance. Au moins une des deux barres peut être fixée par vissage audit au moins un élément de montage, notamment au moyen d'un système de brides.

En particulier, le circuit convertisseur peut comporter deux éléments de montage, par exemple soudés au convertisseur de forte puissance, et la barre de connexion peut présenter une forme en U avec deux barres fixées par vissage sur les deux éléments de montage.

Une telle configuration peut permettre une optimisation de l'assemblage du circuit convertisseur, et notamment de l'assemblage de la barre de connexion. La barre de connexion peut ainsi être démontable.

Alors que les barres de connexion selon l'art antérieur sont assemblées par soudure sur les convertisseurs à forte puissance, la barre de connexion selon l'invention peut par exemple être assemblée par vissage, notamment à l'aide de brides, ce qui peut permettre un gain en termes d'encombrement et un passage de maintenance facilité.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
- la figure 1 représente un exemple de schéma électrique simplifié d'un convertisseur de forte puissance dans le domaine de l'électrolyse selon l'art antérieur,
- la figure 2 représente, en perspective, un convertisseur de puissance équipé d'une barre de connexion selon l'art antérieur,
- la figure 3 représente, en perspective, un convertisseur de puissance équipé d'une barre de connexion selon l'invention,
- la figure 4 représente un exemple d'une partie d'un circuit redresseur comportant une barre de connexion selon l'invention, et
- la figure 5 représente une variante de réalisation de l'exemple de la figure 4, avec une connexion par brides.

Dans l'ensemble de ces figures, des références identiques peuvent désigner des éléments identiques ou analogues.

### EXPOSÉ DÉTAILLÉ DE MODES DE RÉALISATION PARTICULIERS

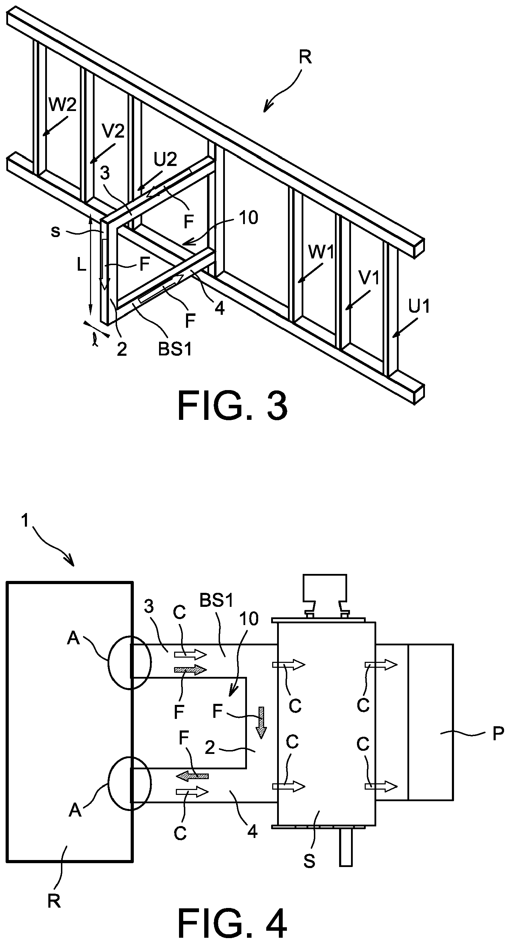

En référence à la figure 3, on a représenté un exemple de convertisseur de forte puissance sous la forme d'un redresseur R comportant une barre de connexion BS1 selon l'invention.

Le redresseur R est destiné à être alimenté en courant alternatif par deux transformateurs triphasés non représentés, et à fournir un courant continu à une série de cuves P d'une usine d'électrolyse via un sectionneur S et deux barres de connexion sous la forme d'une barre de sortie continue DC+ et d'une barre de sortie continue DC-, comme expliqué précédemment.

Sur les figures, seule la barre de sortie continue DC+ BS1 a été représentée mais la barre de sortie continue DC- peut bien évidemment être conçue de façon analogue.

Conformément à l'invention, la barre de connexion BS1 présente une forme délimitant en partie un creux 10.

Plus précisément, la barre de connexion BS1 comporte deux barres 3 et 4 parallèles entre elles, reliées à une même base 2. Les deux barres 3 et 4 sont fixées au redresseur R et la base 2 est fixée au sectionneur S.

Avantageusement, la formation du creux 10 par l'agencement de la barre de connexion BS1 sur le redresseur R permet la circulation du fluide de refroidissement provenant du redresseur R à l'intérieur de la barre de connexion BS1 (le fluide étant matérialisé par les flèches F sur les figures), de façon à permettre également une circulation du fluide au niveau de la barre de connexion du sectionneur S.

La section de raccordement s de la barre de connexion BS1 peut être réduite. En particulier, la longueur L et la largeur l de la section s peuvent être de dimensions réduites, voire équivalentes aux dimensions d'une barre de connexion selon l'art antérieur.

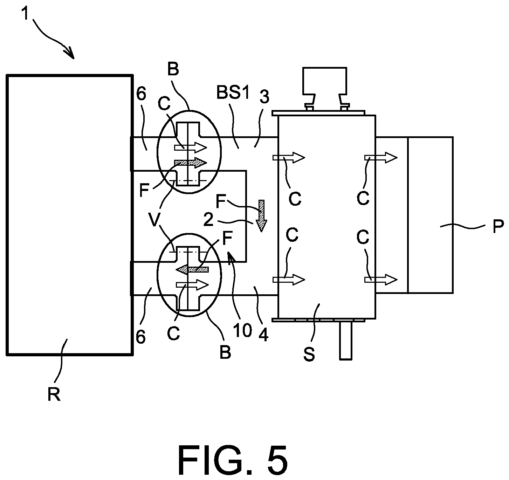

Les figures 4 et 5 représentent deux exemples de réalisation de circuit redresseur 1 conformes à l'invention.

Le circuit redresseur 1 comporte un redresseur R alimentant en courant continu une série de cuves P via un sectionneur S et une barre de connexion BS1 selon l'invention.

Le courant électrique circule depuis le redresseur R dans la barre de connexion BS1 et le sectionneur S (ce courant électrique est matérialisé par les flèches C sur les figures), et le flux de refroidissement circule depuis le redresseur R dans la barre de connexion BS1 pour refroidir la barre de connexion du sectionneur S (ce fluide est matérialisé par les flèches F).

Dans l'exemple de la figure 4, la barre de connexion BS1 comporte deux barres 3 et 4 qui sont fixées au redresseur 4 par soudure au niveau des zones de contact A.

Dans l'exemple de la figure 5, le circuit convertisseur 1 comporte deux éléments de montage 6 qui sont fixés au redresseur R. Les deux éléments de montage 6 et chacune des deux barres 3 et 4 de la barre de connexion BS1 comportent des brides formant un système de brides V pour permettre la fixation par vissage des barres 3 et 4 sur les éléments de montage 6.

Un tel assemblage par vissage de la barre de connexion BS1 sur des éléments de montage 6 solidaires du redresseur R permet de rendre la barre de connexion amovible et de faciliter les opérations de maintenance.

Bien entendu, l'invention n'est pas limitée aux exemples de réalisation qui viennent d'être décrits. Diverses modifications peuvent y être apportées par l'homme du métier.

## Revendications

1. Barre de connexion (BS1) destinée à assurer une connexion électrique entre un convertisseur de forte puissance (R) et un sectionneur (S), la barre étant configurée pour permettre le passage d'un fluide de refroidissement (F) à l'intérieur de celle-ci **caractérisée en ce que** la barre de connexion (BS1) présente une forme en U délimitant, au moins partiellement,
au moins un creux (10),
**en ce qu'**elle comporte deux barres (3, 4) destinées à venir au contact du convertisseur de forte puissance (R), reliées à une même base (2) destinée à venir au contact du sectionneur (S).

2. Barre de connexion selon la revendication 1, **caractérisée en ce qu'**elle est agencée pour que sa forme délimite en partie ledit au moins un creux (10) et pour que l'autre partie dudit au moins un creux (10) soit délimitée par le convertisseur à forte puissance (R).

3. Circuit convertisseur (1) comportant un convertisseur de forte puissance (R) et un sectionneur (S) reliés électriquement entre eux,
**caractérisé en ce qu'**il comporte de plus une barre de connexion (BS1) selon la revendication 1 ou 2 pour assurer une connexion électrique entre le convertisseur de forte puissance (R) et le sectionneur (S).

4. Circuit convertisseur (1) selon la revendication 3, **caractérisé en ce qu'**un même fluide de refroidissement (F) circule dans le convertisseur (R), la barre de connexion (BS1) et le sectionneur (S).

5. Circuit convertisseur (1) selon la revendication 3 ou 4, **caractérisé en ce que** la barre de connexion (BS1) comporte deux barres (3, 4) reliées à une même base (2) et présente une forme en U, les deux barres (3, 4) étant fixées au convertisseur de forte puissance (R) et la base (2) étant fixée au sectionneur (S) .

6. Circuit convertisseur (1) selon la revendication 5, **caractérisé en ce que** les deux barres (3, 4) sont fixées au convertisseur de forte puissance (R) par soudure.

7. Circuit convertisseur (1) selon la revendication 5, **caractérisé en ce qu'**il comporte au moins un élément de montage (6) fixé au convertisseur de forte puissance (R) et **en ce qu'**au moins une des deux barres (3, 4) est fixée par vissage audit au moins un élément de montage (6), notamment au moyen d'un système de brides (V).

## Patentansprüche

1. Verbindungsschiene (BS1) zum Sicherstellen einer elektrischen Verbindung zwischen einem Hochleistungs-Stromrichter (R) und einem Trennschalter (S), wobei die Schiene dazu ausgelegt ist, den Durchgang eines Kühlfluids (F) in ihrem Inneren zu ermöglichen, **dadurch gekennzeichnet, dass** die Verbindungsschiene (BS1) eine U-Form aufweist, die wenigstens teilweise einen Hohlraum (10) begrenzt, und dass sie zwei Schienen (3, 4) umfasst, die dazu ausgelegt sind, in Kontakt mit dem Hochleistungs-Stromrichter (R) zu gelangen, die mit ein und derselben Basis (2) verbunden sind, welche dazu ausgelegt ist, in Kontakt mit dem Trennschalter (S) zu gelangen.

2. Verbindungsschiene nach Anspruch 1, **dadurch gekennzeichnet, dass** sie derart gestaltet ist, dass ihre Form teilweise den wenigstens einen Hohlraum (10) begrenzt, und dass der andere Teil des wenigstens einen Hohlraums (10) durch den Hochleistungs-Stromrichter (R) begrenzt ist.

3. Stromrichterschaltung (1), umfassend einen Hochleistungs-Stromrichter (R) und einen Trennschalter (S), die elektrisch miteinander verbunden sind, **dadurch gekennzeichnet, dass** sie ferner eine Verbindungsschiene (BS1) nach Anspruch 1 oder 2 zum Sicherstellen einer elektrischen Verbindung zwischen dem Hochleistungs-Stromrichter (R) und dem Trennschalter (S) umfasst.

4. Stromrichterschaltung (1) nach Anspruch 3, **dadurch gekennzeichnet, dass** ein und dasselbe Kühlfluid (F) in dem Stromrichter (R), der Verbindungsschiene (BS1) und dem Trennschalter (S) zirkuliert.

5. Stromrichterschaltung (1) nach Anspruch 3 oder 4, **dadurch gekennzeichnet, dass** die Verbindungsschiene (BS1) zwei Schienen (3, 4) umfasst, die mit ein und derselben Basis (2) verbunden sind, und eine U-Form aufweist, wobei die zwei Schienen (3,4) an dem Hochleistungs-Stromrichter (R) befestigt sind, und die Basis (2) an dem Trennschalter (2) befestigt ist.

6. Stromrichterschaltung (1) nach Anspruch 5, **dadurch gekennzeichnet, dass** die zwei Schienen (3, 4) durch Schweißen an dem Hochleistungs-Stromrichter (R) befestigt sind.

7. Stromrichterschaltung (1) nach Anspruch 5, **dadurch gekennzeichnet, dass** sie wenigstens ein Montageelement (6) umfasst, das an dem Hochleistungs-Stromrichter (R) befestigt ist, und dass wenigstens eine der zwei Schienen (3,4) durch Verschrauben an dem wenigstens einen Montageelement (6) befestigt ist, insbesondere mit Hilfe eines Systems von Flanschen (V).

## Claims

1. A busbar (BS1) designed to provide an electrical connection between a high-power converter (R) and a disconnector (S),
said busbar being configured to enable a cooling fluid (F) to pass through the inside of it,
said busbar being **characterized in that** the busbar (BS1) has a U-shape defining, at least in part, at least one hollow portion (10),
**in that** it comprises two bars (3, 4) designed to come into contact with the high-power converter (R), and connected to a common web (2) designed to come into contact with the disconnector (S).

2. A busbar according to claim 1, **characterized in that** it is arranged so that its shape defines said at least one hollow portion (10) at least in part, and so that the other fraction of said at least one hollow portion (10) is defined by the high-power converter (R).

3. A converter circuit (1) including a high-power converter (R) and a disconnector (S) that are interconnected electrically;
said converter circuit being **characterized in that** it also includes a busbar (BS1) according to claim 1 or 2 for the purpose of electrically connecting the high-power converter (R) to the disconnector (S).

4. A converter circuit (1) according to claim 3, **characterized in that** the same cooling fluid (F) flows through the converter (R), through the busbar (BS1) and through the disconnector (S).

5. A converter circuit (1) according to claim 3 or 4, said converter circuit being **characterized in that** the busbar (BS1) comprises two bars (3, 4) connected to a common web (2) and is U-shaped, the two bars (3, 4) being fastened to the high-power converter (R) and the web (2) being fastened to the disconnector (S).

6. A converter circuit (1) according to claim 5, **characterized in that** the two bars (3, 4) are fastened to the high-power converter (R) by welding.

7. A converter circuit (1) according to claim 5, **characterized in that** it includes at least one mounting element (6) fastened to the high-power converter (R) and **in that** at least one of the two bars (3, 4) is fastened by screws to said at least one mounting element (6), in particular by means of a system of flanges (V).
